**Europäisches Patentamt**

**European Patent Office**

**Office européen des brevets**

(11) Veröffentlichungsnummer: **0 248 424 B1**

(12) **EUROPÄISCHE PATENTSCHRIFT**

(45) Veröffentlichungstag der Patentschrift: **12.06.91**

(51) Int. Cl.⁵: **G03F 7/027**, G03F 7/033

(21) Anmeldenummer: **87108067.7**

(22) Anmeldetag: **04.06.87**

(54) **Lichtempfindliches Aufzeichnungselement.**

(30) Priorität: **06.06.86 DE 3619130**

(43) Veröffentlichungstag der Anmeldung:
**09.12.87 Patentblatt 87/50**

(45) Bekanntmachung des Hinweises auf die
Patenterteilung:
**12.06.91 Patentblatt 91/24**

(84) Benannte Vertragsstaaten:
**AT BE CH DE ES FR GB IT LI NL SE**

(56) Entgegenhaltungen:
**EP-A- 0 152 889**   **EP-A- 0 194 440**
**EP-A- 0 209 803**   **DE-A- 2 509 842**
**GB-A- 1 507 664**   **US-A- 3 469 982**
**US-A- 3 796 578**   **US-A- 4 239 849**
**US-A- 4 427 760**

(73) Patentinhaber: **BASF Aktiengesellschaft
Carl-Bosch-Strasse 38
W-6700 Ludwigshafen(DE)**

(72) Erfinder: **Hofmann, Reiner, Dr.
Mandelbergstrasse 44
W-6730 Neustadt(DE)**
Erfinder: **Sanner, Axel, Dr.
Lorscher Ring 2c
W-6710 Frankenthal(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein lichtempfindliches Aufzeichnungselement mit einer auf einem Träger aufgebrachten, wäßrig-alkalisch entwickelbaren, ein polymeres Bindemittel enthaltenden, photopolymerisierbaren Aufzeichnungsschicht, welches insbesondere für die Herstellung von Druckformen oder Resistmustern geeignet ist.

Die bekannten, mit wäßrig-alkalischen Entwicklerlösungen auswaschbaren, lichtempfindlichen Aufzeichnungselemente für die Herstellung von photopolymeren Druckformen oder Resistmustern enthalten auf einem dimensionsstabilen Träger, z.B. einer Kunststoff-Folie oder einem Metallblech, eine photopolymerisierbare Aufzeichnungsschicht aus einer Mischung von mindestens einem in den wäßrig-alkalischen Entwicklerlösungen löslichen oder dispergierbaren polymeren Bindemittel, mindestens einer ethylenisch ungesättigten, photopolymerisierbaren, niedermolekularen Verbindung, mindestens einem Photoinitiator sowie gegebenenfalls weiteren, die verarbeitungs- und/oder anwendungstechnischen Eigenschaften verbessernden und/oder modifizierenden Zusatz- und/oder Hilfsstoffen.

Als polymere Bindemittel für die wäßrig-alkalisch entwickelbaren photopolymerisierbaren Aufzeichnungsschichten gelangen hierbei insbesondere in den wäßrig-alkalischen Entwicklerlösungen lösliche oder zumindest dispergierbare, carboxylgruppenhaltige oder Carbonsäureanhydrid-Gruppen enthaltende Copolymerisate zur Anwendung, wie z.B. Styrol/Maleinsäureanhydrid-Copolymerisate, Styrol/Maleinsäurehalbester-Copolymerisate, Alkyl-(meth)acrylat/(Meth)acrylsäure-Copolymerisate oder auch Copolymerisate aus Styrol, Alkyl(meth)-acrylaten und (Meth)acrylsäure sowie gegebenenfalls weiteren Comonomeren (vgl. u.a. DE-B-20 27 467, SU-PS 190 211, DE-A-22 05 146, EP-A-49 504 oder DE-A-27 36 058). In der US-PS 3 796 578 sind photopolymerisierbare Gemische aus Veresterungsprodukten von carboxylgruppenhaltigen Copolymerisaten mit ethylenisch ungesättigten Verbindungen, die einen Oxiranring tragen, einer ethylenisch ungesättigten Verbindung und einem Photopolymerisationsinitiator sowie deren Verwendung zur Herstellung von Offset-Druckplatten beschrieben. Die Verträglichkeit dieser Produkte ist jedoch noch verbesserungsbedürftig. Auch wurde schon vorgeschlagen, in photopolymerisierbaren Mischungen als polymeres Bindemittel amphotere Copolymerisate einzusetzen, die aus einem basischen Comonomer, wie z.B. N-Alkyl(meth)acrylamiden oder Alkyl-aminoalkyl-(meth)acrylaten, einem sauren Comonomeren, z.B. (Meth)acrylsäure, sowie mindestens einem weiteren Comonomeren, wie z.B. Alkyl(meth)acrylaten, Hydroxyalkyl(meth)acrylaten, Vinylestern oder Styrol bestehen (vgl. US-PS 4 293

635).

Die bekannten, wäßrig entwickelbaren lichtempfindlichen Aufzeichnungsmaterialien sind wohl bereits für viele Anwendungszwecke brauchbar und geeignet, lassen jedoch hinsichtlich einer Reihe ihrer Eigenschaften noch zu wünschen übrig. So sind sie im photopolymerisierten Zustand häufig zu empfindlich gegenüber dem Auswasch-Medium, d.h. die Überwaschempfindlichkeit beim Entwickeln ist groß. Feine ßildelemente sind mit diesen Aufzeichnungsmaterialien vielfach nur schwer zu reproduzieren, und es müssen bei den Auswaschbedingungen sehr enge Grenzen bezüglich Auswaschzeit, Temperatur und Zusammensetzung der Entwicklerlösung eingehalten werden. Ferner kommt es bei den bekannten, wäßrig-alkalisch entwickelbaren Aufzeichnungsmaterialien leicht zu Restschicht-Bildungen bei der Entwicklung, d.h. die bei der bildmäßigen Belichtung nicht photopolymerisierten Anteile der Aufzeichnungsschicht lassen sich nicht restlos und einwandfrei vom Träger entfernen. Diese Erscheinung, die insbesondere bei Einsatz von metallischen Trägern oder Substraten für die photopolymerisierbare Aufzeichnungsschicht auftritt, ist vor allem bei der Herstellung von Resistmustern und Flachdruckplatten hinderlich.

Aus der EP-A-O 152 889 ist ein lichtempfindliches Aufzeichnungsmaterial, insbesondere für die Herstellung von Flachdruckplatten oder Resistmustern, mit einer ein Bindemittel enthaltenden, wäßrig entwickelbaren, lichtempfindlichen Aufzeichnungschicht bekannt, wobei in der lichtempfindlichen Aufzeichnungsschicht als polymeres Bindemittel ein in wäßrigem Medium, insbesondere wäßrig-alkalischen Medien, lösliches oder zumindest dispergierbares Copolymerisat enthalten ist, welches als Comonomeres ein Anhydrid einer polymerisierbaren, ethylenisch ungesättigten Monocarbonsäure, insbesondere Methacrylsäureanhydrid, in einer Menge von 0,05 bis 2 Gew.%, bezogen auf das Copolymerisat, einpolymerisiert enthält.

Aufgabe der vorliegenden Erfindung war es, neue lichtempfindliche Aufzeichnungselemente mit einer wäßrig-alkalisch entwickelbaren photopolymerisierbaren Aufzeichnungsschicht aufzuzeigen, die für die Herstellung von photopolymeren Druckformen oder Resistmustern geeignet sind. Insbesondere war es Aufgabe der vorliegenden Erfindung, solche lichtempfindlichen Aufzeichnungselemente zu schaffen, die eine gute Entwickelbarkeit und einen möglichst großen Entwicklungsspielraum beim Auswaschen mit wäßrig-alkalischen Entwicklerlösungen aufweisen, ohne daß hierbei ihr allgemeines Eigenschaftsprofil negativ verändert wird. Die photopolymerisierbaren, wäßrig-alkalisch entwickelbaren Aufzeichnungsschichten sollen dabei insbesondere gegenüber metallischen Trägern oder Substraten gute Haftung aufweisen, ohne daß es jedoch bei der Verarbeitung zur Restschicht-Bildung in den auszuwaschenden Bereichen kommt.

Es wurde nun überraschenderweise gefunden, daß diese Aufgabe durch lichtempfindliche Aufzeichnungselemente mit einer auf einem dimensionsstabilen Träger aufgebrachten, wäßrig-alkalisch entwickelbaren photopolymerisierbaren Aufzeichnungsschicht gelöst wird, wenn die photopolymerisierbare Aufzeichnungsschicht als polymeres Bindemittel mindestens ein in Wasser unlösliches, in wäßrig-alkalischen Lösungen jedoch lösliches oder zumindest dispergierbares, filmbildendes Copolymerisat enthält, welches aus 10 bis 50 Gew.% mindestens eines Hydroxyalkyl(meth)acrylats, 8 bis 30 Gew.% an Acrylsäure und/oder Methacrylsäure sowie 30 bis 80 Gew.% mindestens eines Alkylacrylats, Alkylmethacrylats und/oder eines Vinylaromaten in einpolymerisierter Form besteht und die Carboxylgruppen des Copolymerisats teilweise durch Umsetzung mit Glycidylacrylat oder Glycidylmethacrylat verestert sind.

Gegenstand der Erfindung ist dementsprechend ein zur Herstellung von Druckformen oder Resistmustern geeignetes lichtempfindliches Aufzeichnungselement mit einer auf einem dimensionsstabilen Träger aufgebrachten, wäßrig-alkalisch entwickelbaren, ein polymeres Bindemittel, mindestens eine ethylenisch ungesättigte, photopolymerisierbare niedermolekulare Verbindung, mindestens einen Photopolymerisationsinitiator bzw. ein Photopolymerisationinitiatorsystem sowie gegebenenfalls weitere Zusatz- und/oder Hilfsstoffe enthaltenden, photopolymerisierbaren Aufzeichnungsschicht, die als polymeres Bindemittel mindestens ein in Wasser unlösliches, in Wäßrigalkalischen Lösungen jedoch lösliches oder zumindest dispergierbares, filmbildendes Copolymerisat aus Hydroxyalkyl (meth) acrylat, Acrylsäure und/oder Methacrylsäure sowie mindestens eines Monomeren aus der Gruppe Alkylacrylat, Alkylmethacrylat und Vinylaromat enthält, das dadurch gekennzeichnet ist, daß das Copolymerisat aus 10 bis 50 Gew.% mindestens eines Hydroxyalkylacrylats und/oder Hydroxyalkylmethacrylats, 8 bis 30 Gew.% Acrylsäure und/oder Methacrylsäure und 30 bis 80 Gew.% mindestens eines Monomeren aus der Gruppe Alkylacrylat, Alkylmethacrylats und Vinylaromat, wobei die Carboxylgruppen des Copolymerisats teilweise durch Umsetzung mit Glycidyl(meth)-acrylat verestert sind, besteht.

Das polymere Bindemittel enthält also (a) 10 bis 50 Gew.% mindestens eines Hydroxyalkyl-(meth)acrylats, (b) 8 bis 30 Gew.% Acrylsäure und/oder Methacrylsäure sowie (c) 30 bis 80 Gew.% mindestens eines Alkylacrylats, Alkylmethacrylats und/oder eines Vinylaromaten, einpolymerisiert, wobei die Summe der unter (a) bis (c) genannten Prozentzahlen 100 ist, mit der Maßgabe, daß ein Teil der Carboxylgruppen des Copolymerisats, vorzugsweise 10 bis 60 % der Carboxylgruppen durch Umsetzung mit Glycidylacrylat oder Glycidylmethacrylat verestert sind.

Durch den erfindungsgemäßen Einsatz der speziellen Copolymerisate als polymerem Bindemittel in den photopolymerisierbaren Aufzeichnungsschichten werden lichtempfindliche Aufzeichnungselemente mit vorteilhaften, teilweise überraschend verbesserten Eigenschaften erhalten. Besonders geeignet sind solche Aufzeichnungselemente, bei denen 10 bis 60 % der Carboxylruppen des Copolymerisats mit Glycidyl(meth)acrylat verestert sind, bzw. solche, deren mit Glycidyl(meth)-acrylat teilweise veresterten Copolymerisate Säurezahlen von 20 bis 100 mg KOH/g aufweisen. So zeigen die lichtempfindlichen Aufzeichnungselemente nach der bildmäßigen Belichtung mit aktinischem Licht trotz eines vergleichsweise niederen Gehalts an Acrylsäure und/oder Methacrylsäure in den erfindungsgemäß einzusetzenden Copolymerisaten eine gute Entwickelbarkeit in wäßrig-alkalischen Entwicklerlösungen bei gleichzeitig guter Beständigkeit im photopolymerisierten Zustand gegenüber wäßrigen Medien, wie sie beispielsweise beim Einsatz der Druckformen oder Resistmuster zur Anwendung gelangen. Die erfindungsgemäßen lichtempfindlichen Aufzeichnungselemente weisen eine geringe Überwaschempfindlichkeit bei der Entwicklung auf, die photopolymerisierbare Aufzeichnungsschicht ist auch auf metallischen Trägern oder Substraten stabil bei gleichzeitig guter Haftung zu diesen Trägern oder Substraten, und sie erlauben die exakte und sichere Reproduktion auch von feinen Bildelementen, beispielsweise Linien von 100μm Breite oder darunter.

Bei den erfindungsgemäß in der photopolymerisierbaren Aufzeichnungsschicht der lichtempfindlichen Aufzeichnungselemente enthaltenen polymeren Bindemitteln handelt es sich um spezielle Copolymerisate von Hydroxyalkyl-(meth)acrylaten, die in reinem Wasser unslöslich sind, in wäßrig-alkalischen Lösungen jedoch löslich oder zumindest dispergierbar sind. Bevorzugt sind die Hydroxyalkyl-(meth)acrylat-Copolymerisate in wäßrig-alkalischen Lösungen mit einem pH-Wert größer als 9, insbesondere im Bereich von 9 bis 13 löslich oder zumindest dispergierbar, in wäßrig-alkalischen Lösungen mit pH-Werten unter 9 jedoch unlöslich. Die erfindungsgemäß einzusetzende Copolymerisate sollen filmbildend sein und haben beispielsweise ein mittleres Molekulargewicht (Gewichtsmittel) größer als 10.000, vorzugsweise im Bereich von 15.000 bis 500.000 und insbesondere im Bereich von 20.000 bis 250.000.

Die erfindungsgemäß einzusetzenden, durch teilweise Veresterung der Carboxylgruppen mit Glycidyl(meth)acrylat erhaltenen Copolymerisate werden auf übliche Weise erhalten durch Copolymerisation von Hydroxyalkyl(meth)acrylaten, (Meth)acrylsäure sowie Alkyl(meth)acrylaten und/oder Vinylaromaten. Die Copolymerisate können ein oder mehrere Comonomere der einzelnen Comonomer-Arten einpolymerisiert enthalten, d.h. sie können aus einem oder mehreren Hydroxyalkylacrylaten und/oder Hydroxyalkylmethacrylaten, Acrylsäure und/oder Methacrylsäure sowie einem oder mehreren Alkylacrylaten, Alkylmethacrylaten und/oder Vinylaromaten aufgebaut sein. Ein Teil der Carboxylgruppen des Copolymerisats wird mit Glycidylacrylat oder Glycidylmethacrylat verestert.

Als Hydroxyalkyl-(meth)acrylate kommen insbesondere die Hydroxalkylacrylate und/oder Hydroxyalkylmethacrylate mit 2 bis 4 C-Atomen im Hydroxyalkyl-Rest in Betracht. Vorzugsweise handelt es sich bei dieser Gruppe von Comonomeren um die Monoacrylate und Monomethacrylate von Alkandiolen, wie insbesondere Ethylenglykol, 1,2-Propandiol, 1,3-Propandiol. Als Beispiele für die Hyroxyalkyl-(meth)acrylat-Comonomeren seien genannt 2-Hydroxyethylacrylat, 2-Hydroxyethylmethacrylat, 2-Hydroxypropylacrylat, 3-Hydroxypropylacrylat, 2-Hydroxypropylmethacrylat, 3-Hydroxypropylmethacrylat sowie insbesondere Mischungen von 2-Hydroxypropyl- und 3-Hydroxypropyl-(meth)acrylat. Der Anteil der in den erfindungsgemäß einzusetzenden Copolymerisaten einpolymerisierten Hydroxyalkyl-(meth)acrylat-Comonomeren liegt im Bereich von 10 bis 50 Gew.%, vorzugsweise im Bereich von 15 bis 45 Gew.%, bezogen auf das Copolymerisat.

Als zweite Gruppe von Comonomeren enthalten die Copolymerisate Acrylsäure und/oder Methacrylsäure in einer Menge von 8 bis 30, insbesondere 10 bis 20 Gew.%, bezogen auf das Copolymerisat, einpolymerisiert.

Als Beispiele für die Gruppe der Alkyl-(meth)acrylat-Comonomeren seien insbesondere die Acrylate und Methacrylate von geradkettigen oder verzweigten Monoalkanolen mit 1 bis 8 C-Atomen, vorzugsweise mit 1 bis 4 C-Atomen genannt. Die Alkylacrylate und/oder Alkylmethacrylate können vollständig oder vorzugsweise teilweise, in Mengen von 1 bis 40 Gew.%, bezogen auf die Gesamtmenge der im Copolymerisat einpolymerisierten Comonomeren durch Vinylaromaten, wie Styrol, Vinyltoluol oder α-Methylstyrol ersetzt sein. Der Anteil der Alkyl(meth)acrylat- und/oder Vinylaromaten-Comonomereinheiten im Copolymerisat liegt im Bereich von 30 bis 80 Gew.%, vorzugsweise 40 bis 70 Gew.%, bezogen auf das Copolymerisat. Die Grenzen für den Anteil der einzelnen Comonomer-Gruppen in den Copolymerisaten sind im Hinblick auf deren allgemeine Eigenschaften und speziell der hiermit hergestellten, erfindungsgemäßen lichtempfindlichen Aufzeichnungselemente von Bedeutung.

Beispiele für Copolymerisate, die sich nach teilweiser Veresterung der Carboxylgruppen mit Glycidyl(meth)acrylat für den Einsatz als polymeres Bindemittel in den photopolymerisierbaren Aufzeichnungsschichten der erfindungsgemäßen lichtempfindlichen Aufzeichnungselemente als besonders vorteilhaft erwiesen haben, sind Hydroxypropylacrylat/ Methacrylsäure/ Methylmethacrylat-Copolymerisate, Hydroxypropylacrylat/ Acrylsäure/ Methylmethacrylat-Copolymerisate sowie Hydroxyethylmethacrylat)-Methacrylsäure/Methylmethacrylat-Copolymerisate, die die Comonomeren in den vorstehend angegebenen Mengenverhältnissen einpolymerisiert enthalten.

Die erfindungsgemäß als polymeres Bindemittel einzusetzenden Copolymerisate können nach den an sich bekannten und üblichen Polymerisationsmethoden durch Copolymerisation der Comonomeren, beispielsweise in Lösung, hergestellt werden. Für die Lösungspolymerisation eignen sich beispielsweise niedere Alkanole, Ketone, Ester und ähnliche als Lösungsmittel. Als Polymerisationsinitiatoren kommen beispielsweise die üblichen radikalischen Starter, wie beispielsweise Azo-bis-isobutyronitril und/oder Benzoylperoxid in Betracht. Die Polymerisationstemperatur liegt üblicherweise zwischen 50 und 100° C.

Die teilweise Veresterung mit Glycidylacrylat und/oder Glycidylmethacrylat erfolgt in üblicher Weise durch Umsetzung der carboxylgruppenhaltigen Copolymerisate mit Glycidyl(meth)acrylat bei 60 bis 120° C, vorzugsweise in inerten Lösungsmitteln, wie Methylethylketon oder Glykoldialkylethern.

Zweckmäßigerweise kann die Funktionalisierung der carboxylgruppenhaltigen Copolymerisate mit Glycidyl(meth)acrylat folgendermaßen erfolgen: 10 bis 20 %ige Lösungen der carboxylgruppenhaltigen Copolymerisate in Diethylenglycoldimethylether werden vorgelegt und bei 110° C eine Lösung bestehend aus 30 Teilen Glycidyl(meth)acrylat, 2 Teilen thermischem Inhibitor (z.B. Xyligen Al) und 2 Teilen Katalysator (z.B. Dimethylaminopyridin, N-Methylimidazol oder Tetrabutylammoniumiodid) innerhalb von 2 Stunden zugetropft. Die Reaktion ist im allgemeinen nach 3,5 Stunden beendet. Die kalte Reaktionsmischung kann auf 1 bis 5 % Feststoffgehalt verdünnt und in Wasser ausgefällt werden. Das ausgefällte Copolymerisat kann dann in üblicher Weise abfiltriert und getrocknet werden.

In der photopolymerisierbaren Aufzeichnungsschicht der erfindungsgemäßen lichtempfindlichen Aufzeichnungselemente können ein oder mehrere Hydroxyalkyl-(meth)acrylat-Copolymerisate der in Rede stehenden Art als polymeres Bindemittel enthalten sein. Neben dem polymeren Bindemittel enthält die photopolymerisierbare Aufzeichnungsschicht noch mindestens eine ethylenisch ungesättigte, photopolymerisierbare, niedermolekulare Verbindung, mindestens einen Photopolymerisationsinitiator bzw. ein Photopolymerisationsinitiatorsystem sowie gegebenenfalls weitere Zusatz- und/oder Hilfsstoffe zur Verbesserung bzw. Modifizierung der allgemeinen Eigenschaften der lichtempfindlichen Aufzeichnungselemente bzw. der hieraus hergestellten Druckformen oder Resistmuster.

Als ethylenisch ungesättigte, photopolymerisierbare niedermolekulare Verbindungen kommen sowohl Monomere als auch ethylenisch ungesättigte, photopolymerisierbare Oligomere mit einem Molekulargewicht bis 5.000 in Betracht, wobei die photopolymerisierbaren niedermolekularen Verbindungen sowohl mono- als auch mehrfunktionell sein können, d.h. eine oder mehrere photopolymerisierbare, ethylenische Doppelbindungen besitzen können. Üblicherweise sind in der photopolymerisierbaren Aufzeichnungsschicht di-oder mehrfunktionelle ethylenisch ungesättigte, photopolymerisierbare niedermolekulare Verbindungen allein oder Mischungen hiervon mit einem untergeordneten Anteil an monofunktionellen ethylenisch ungesättigten, photopolymerisierbaren niedermolekularen Verbindungen enthalten. Als Vertreter für die ethylenisch ungesättigten, photopolymerisierbaren, niedermolekularen Verbindungen, die in der photopolymerisierbaren Aufzeichnungsschicht allein oder auch in Mischung miteinander enthalten sein können, seien insbesondere die Derivate der Acrylsäure und Methacrylsäure und hier vor allem die (Meth)acrylsäureester genannt. Beispiele hierfür sind die Di- und Tri-(meth)acrylate von Di- oder Polyolen wie Ethylenglykol, Diethylenglykol, Triethylenglykol, Polyethylenglykolen mit einem Molekulargewicht bis 500, 1,2-Propandiol, 1,3-Propandiol, Polypropylenglykolen mit einem Molekulargewicht bis 500, 1,4-Butandiol, 1,1,1-Trimethylolpropan, 2,2-Dimethylpropandiole, Glycerin oder Pentaerythrit; Pentaerythrittetra-(meth)acrylat, Glukosetri- oder -tetra-(meth)acrylat; ferner die Monoacrylate und Monomethacrylate der genannten Diole und Polyole, wie z.B. Ethylenglykol-, Di-, Tri- oder Tetraethylenglykol-mono(meth)acrylat, Propandiol-mono(meth)acrylat und Butandiol-mono(meth)-acrylat, und die (Meth)acrylate von Monoalkanolen, insbesondere solche von Monoalkanolen mit 1 bis 20 C-Atomen. Ferner sind als ethylenisch ungesättigte, photopolymerisierbare niedermolekulare Verbindungen die monomeren und oligomeren Urethanacrylate und -methacrylate mit zwei oder mehr Acryloyl- und/oder Methacryloyl-Gruppen im Molekül zu nennen. Solche monomeren oder oligomeren Urethan-(meth)acrylate, die gegebenenfalls neben den Acryloyl- und/oder Methacryloyl-Gruppen auch noch freie Carboxylgruppen enthalten können, sind nach üblichen und an sich bekannten Verfahren erhältlich, beispielsweise durch Umsetzung von Diolen oder Polyolen der vorstehend genannten Art mit Di- oder Polyisocyanaten, beispielsweise Hexamethylendiisocyanat, Isophorondiisocyanat oder ähnlichen, unter Bildung eines Reaktionsprodukts mit freien Isocyanatgruppen und Umsetzung dieser Isocyanatgruppen mit beispielsweise Hydroxyalkyl(meth)acrylaten. Man kann auch zunächst die Hydroxyalkyl-(meth)acrylate mit den Di- oder Polyisocyanaten umsetzen und das resultierende ungesättigte Isocyanat anschließend mit der Diol-oder Polyolkomponente zur Reaktion bringen. Zur Einführung von freien Carboxyl-Gruppen in die Urethan-Verbindungen kann ein Teil der Hydroxylgruppen der Diol- bzw. vorzugsweise Polyol-Komponente mit mehrfachen Carbonsäuren bzw. insbesondere cyclischen Dicarbonsäureanhydriden unter Bildung der sauren Teilester der Carbonsäuren umgesetzt werden. Geeignete ethylenisch ungesättigte, photopolymerisierbare niedermolekulare Verbindungen für die erfindungsgemäßen lichtempfindlichen Aufzeichnungselemente sind auch die Acryloyl- und/oder Methacryloyl-Gruppen enthaltenden Verbindungen, wie sie erhalten werden durch Umsetzung von Acrylsäure und/ oder Methacrylsäure mit Di- oder Polyepoxid-Verbindungen.

Neben den bevorzugt verwendeten Acrylaten und Methacrylaten, insbesondere der vorstehend genannten Art, seien als ethylenisch ungesättigte, photopolymerisierbare niedermolekulare Verbindungen auch die Allyl-Verbindungen und andere Vinyl-Verbindungen genannt, wie z.B. N-Vinylpyrrolidon, N-Vinylcaprolactam, Vinylacetat, Vinylpropionat, (Meth)acrylamid, N-Methylol-(meth)acrylamid, der Bisether des Ethylenglykols und des N-Methylol-(meth)acrylamids, Vinylcarbamate und Bisacrylamidoessigsäure.

Die ethylenisch ungesättigten, photopolymerisierbaren niedermolekularen Verbindungen werden dabei - für den Fachmann selbstverständlich - so gewählt, daß sie mit den als polymeren Bindemitteln eingesetzten Hydroxyalkyl-(meth)acrylat-Copolymerisaten verträglich sind. Das Mengenverhältnis von polymerem Bindemittel zu den ethylenisch ungesättigten, photopolymerisierbaren niedermolekularen Verbindungen in der photopolymerisierbaren Aufzeichnungsschicht kann in weiten Grenzen, beispielsweise im Bereich von 5:95 bis 90:10 variiert werden und liegt insbesondere im Bereich von 40:60 bis 90:10. Der Anteil der polymeren Bindemittel und ethylenisch ungesättigten, photopolymerisierbaren niedermolekularen Verbindungen in der photopolymerisierbaren Aufzeichnungsschicht richtet sich neben der Art dieser Verbindungen, insbesondere nach dem gewünschten Eigenschaftsbild der lichtempfindlichen Aufzeichnungselemente bzw. der hieraus hergestellten Druckformen oder Resistmuster. Dieses Verhältnis kann beispielsweise so gewählt werden, daß die photopolymerisierbare Aufzeichnungsschicht bei Raumtemperatur fest ist. Dies gilt insbesondere für den Einsatz der erfindungsgemäßen lichtempfindlichen Aufzeichnungsmaterialien als Photoresistfilm. Im übrigen sind die Kriterien für die Auswahl des Verhältnisses von polymerem Bindemittel zu ethylenisch ungesättigter, photopolymerisierbarer niedermolekularer Verbindung in Abhängigkeit von der Art dieser Verbindungen dem Fachmann geläufig.

Als Photopolymerisationsinitiatoren für die photopolymerisierbaren Aufzeichnungsschichten kommen die für lichtempfindliche, photopolymerisierbare Aufzeichnungsmaterialien üblichen und an sich bekannten Photoinitiatoren bzw. Photoinitiator-Systeme in Betracht. Beispielhaft seien hier genannt: Benzoin, Benzoinether, insbesondere Benzoinalkylether, substituierte Benzoine, Alkylether von substituierten Benzoinen, wie beispielsweise α-Methylbenzoinalkylether oder α-Hydroxymethylbenzoinalkylether; Benzile, Benzilketale, insbesondere Benzildimethylketal, Benzilmethylethylketal oder Benzilmethylbenzylketal; die als Photoinitiator wirksamen Acylphosphinoxid-Verbindungen, wie z.B. substituierte Benzoyl-diarylphosphinoxide; Benzophenon, Derivate des Benzophenons, 4,4'-Dimethylaminobenzophenon, 4,4'-Diethylaminobenzophenon, Derivate von Michlers Keton; Anthrachinon und substituierte Anthrachinone; arylsubstituierte Imidazole oder deren Derivate, wie z.B. 2,4,5-Triarylimidazoldimere; 2-Chlorthioxanthon und die als Photoinitiatoren wirksamen Acridin-oder Phenacin-Derivate. Beispiele für Initiatorsysteme sind Kombinationen der genannten Initiatoren mit Sensibilisierungshilfsmitteln oder Aktivatoren, wie insbesondere tertiären Aminen. Typische Beispiele für solche Initiatorsysteme sind Kombinationen aus Benzophenon oder Benzophenon-Derivaten mit tertiären Aminen, wie Triethanolamin oder Michlers Keton, oder Gemische aus 2,4,5-Triarylimidazoldimeren und 2-Mercaptobenzochinazol oder den Leukobasen von Triphenylmethanfarbstoffen. Die Auswahl der geeigneten Photoinitiatoren bzw. Photoinitiator-Systeme ist dem Fachmann geläufig. Die Photoinitiatoren bzw. Photoinitiator-Systeme sind in der photopolymerisierbaren Aufzeichnungsschicht in Mengen von 0,001 bis 10 Gew.%, insbesondere in Mengen von 0,05 bis 5 Gew.%, bezogen auf die photopolymerisierbare Aufzeichnungsschicht, enthalten.

Als weitere Zusatz- und/oder Hilfsstoffe, die in der photopolymerisierbaren Aufzeichnungsschicht der erfindungsgemäßen lichtempfindlichen Aufzeichnungselemente enthalten sein können, kommen z.B. thermische Polymerisationsinhibitoren, Farbstoffe und/oder Pigmente, photochrome Verbindungen bzw. Systeme, sensitometrische Regler, Weichmacher, ·Verlaufshilfsmittel, Füllstoffe, Verstärkungsmittel, Mattierungs- oder Gleitmittel und dgl. in Betracht. Geeignete thermische Polymerisationsinhibitoren sind z.B. Hydrochinon, Hydrochinon-Derivate, 2,6-Di-t.-butyl-p-kresol, Nitrophenole, N-Nitrosoamine, wie N-Nitrosodiphenylamin oder die Salze des N-Nitrosocyclohexylhydroxylamins. Beispiele für Farbstoffe und/oder Pigmente, die sowohl als Kontrastmittel als auch schichtverfestigend wirken können, sind unter anderem Brilliant Green Dye (C.I. 42 040), Victoria Reinblau FGA, Victoria Reinblau BO (C.I. 42 595), Malachitgrün, Kristallviolett, Victoria-Blau B (C.I. 44 045), Rodamin-6 (C.I. 45 160), Naphthalimidfarbstoffe, Azosole und 3'-Phenyl-7-dimethylamino-2,2'-spiro-di-(2H-1-benzopyran). Photochrome Systeme, die bei Belichtung mit aktinischem Licht ihre Farbe reversibel oder irreversibel ändern, ohne hierbei den Photopolymerisationsprozeß zu stören, sind z.B. Leuko-Farbstoffe zusammen mit geeigneten Aktivatoren. Als Beispiele für Leuko-Farbstoffe seien die Leuko-Basen der Triphenylmethanfarbstoffe, wie Kristallviolett-Leukobase und Malachitgrün-Leukobase, Leuko-Basisch-Blau, Leuko-Pararosanilin, Leuko-Patentblau A und V genannt; ferner kommt auch Rhodamin B-Base in Betracht. Als Aktivatoren für diese photochromen Verbindungen kommen unter anderem organische Halogenverbindungen, die bei Bestrahlung mit aktinischem Licht Halogenradikale abspalten, oder Hexaarylbisimidazole in Betracht. Zu den sensitometrischen Reglern gehören Verbindungen wie z.B. 9-Nitroanthracen, 10,10'-Bisanthron, Phenazinium-, Phenoxazinium-, Acridinium- oder Phenothiazinium-Farbstoffe, insbesondere in Kombination mit milden Reduktionsmitteln, 1,3-Dinitrobenzole und ähnliche. Als Weichmacher können die an sich bekannten und üblichen niedermolekularen oder hochmolekularen Ester, wie Phthalate oder Adipate, Benzol-, bzw. Toluolsulfonamid oder Tricresylphosphat, dienen. Die Zusatz- und/oder Hilfsstoffe sind in den photopolymerisierbaren Aufzeichnungsschichten in den für diese Zusatzstoffe üblichen und bekannten wirksamen Mengen vorhanden. Ihre Menge sollte jedoch 30 Gew.%, vorzugsweise 20 Gew.%, bezogen auf die photopolymerisierbare Aufzeichnungsschicht, nicht überschreiten.

Das Mischungsverhältnis, in dem die einzelnen Komponenten in der photopolymerisierbaren Aufzeichnungsschicht vorhanden sind, kann beispielsweise so gewählt werden, daß die Aufzeichnungsschicht nicht nur wäßrig-alkalisch entwickelbar, sondern vorteilhafterweise auch bei Raumtemperatur fest ist und gute Filmbildungseigenschaften besitzt. Für die Verwendung als Photoresistfilm wird die Zusammensetzung darüber hinaus so gewählt, daß die photopolymerisierbare Aufzeichnungsschicht gut laminierbar und unter Anwendung von Druck sowie gegebenenfalls Wärme auf ein Substrat übertragbar ist. Die Dicke der photopolymerisierbaren Aufzeichnungsschicht richtet sich bekanntermaßen nach dem Anwendungszweck der lichtempfindlichen Aufzeichnungselemente und kann dementsprechend in weiten Grenzen schwanken. Während sie für die Herstellung von Resistmustern im allgemeinen im Bereich von beispielsweise 1 bis 50 μm liegt, kommen für die Herstellung von Hochdruckformen beispielsweise Schichtdicken von etwa 100 μm bis einigen mm in Betracht.

In einer typischen Ausführungsform der Erfindung besteht die photopolymerisierbare Aufzeichnungsschicht der lichtempfindlichen Aufzeichnungselemente aus einer homogenen, filmbildenden und in wäßrig-alkalischen Entwicklerlösungen löslichen oder zumindest dispergierbaren Mischung von

a) 40 bis 90 Gew.% mindestens eines mit Glydiyl(meth)acrylat teilweise veresterten Copolymerisats der vorstehend genannten Art als polymerem Bindemittel,

b) 8 bis 55 Gew.% mindestens einer ethylenisch ungesättigten, photopolymerisierbaren niedermolekularen Verbindung mit 2 oder mehr polymerisierbaren Doppelbindungen oder Mischungen hiervon mit einem untergeordneten Anteil an ethylenisch ungesättigten, photopolymerisierbaren, niedermolekularen Verbindungen mit nur einer photopolymerisierbaren Doppelbindung, wobei die ethylenisch ungesättigten, photopolymerisierbaren niedermolekularen Verbindungen mit dem polymeren Bindemittel verträglich sein sollen,

c) 0,001 bis 10 Gew.% mindestens eines Photopolymerisationsinitiators bzw. eines Photopolymerisationsinitiator-Systems sowie

d) 0 bis 30 Gew.%, insbesondere 0,05 bis 20 Gew.%, an weiteren, die allgemeinen Eigenschaften der lichtempfindlichen Aufzeichnungselemente bzw. der hieraus hergestellten Druckformen oder Resistmuster verbessernden bzw. modifizierenden Zusatz- und/oder Hilfsstoffen, beispielsweise übliche Weichmacher in Mengen von 0,5 bis 5, insbesondere 1 bis 3 Gew.%.

Als Träger für die photopolymerisierbaren Aufzeichnungsschichten kommen die für lichtempfindliche Aufzeichnungselemente der in Rede stehenden Art an sich bekannten und üblichen, dimensionsstabilen, starren oder vorzugsweise flexiblen Schichtträger in Betracht, wobei die Art des Schichtträgers vom Verwendungszweck der lichtempfindlichen Aufzeichnungselemente mitbestimmt wird. So kommen für die Herstellung von Druckplatten als dimensionsstabile Träger insbesondere Kunststoff-Filme oder -Folien, z.B. Polyesterfolien, sowie metallische Schichtträger, beispielsweise Stahl-oder Aluminiumbleche, in Betracht. Für Photoresistfilme und Schichtübertragungsmaterialien finden als Trägermaterialien vorzugsweise Kunststoff-Filme oder -Folien, z.B. Polyesterfolien, Verwendung, die eine mäßige Haftung zu der photopolymerisierbaren Aufzeichnungsschicht haben und nach dem Auflaminieren bzw. Aufkaschieren der photopolymerisierbaren Aufzeichnungsschicht auf ein Substrat von dieser - wahlweise vor oder nach der bildmäßigen Belichtung mit aktinischem Licht - abgezogen werden können. Für die Herstellung von Resistmustern kann die photopolymerisierbare Aufzeichnungsschicht auch direkt auf das zu schützende sowie gegebenenfalls dauerhaft zu modifizierende Substrat aufgebracht werden, welches dann als Schichtträger für die photopolymerisierbare Aufzeichnungsschicht dient. Als Substrate für Photoresistschichten kommen beispielsweise Kupferbleche, kupferkaschierte Basismaterialien, Keramiksubstrate, die mit metallischen oder metalloxidischen Schichten beschichtet sind, Halbleiterelemente sowie Silicium-Wafer in Betracht. Die Trägermaterialien für die photopolymerisierbare Aufzeichnungsschicht können gegebenenfalls in an sich bekannter Weise, z.B. mechanisch, chemisch, elektrochemisch und/oder durch Versehen mit einer Haftgrundierung, vorbehandelt sein. Gleichermaßen können zwischen photopolymerisierbarer Aufzeichnungsschicht und Träger auch noch eine oder mehrere Zwischenschichten angeordnet sein, die bei lichtempfindlichen Aufzeichnungselementen für die Herstellung von Druckformen beispielsweise als Haftschichten und/oder Lichthofschutzschichten ausgebildet sein können.

Ebenso kann auf der dem Träger abgewandten Oberfläche der photopolymerisierbaren Aufzeichnungsschicht auch noch eine Deckschicht oder Deckfolie angeordnet sein, die vorzugsweise in der gleichen Entwicklerlösung löslich ist wie die photopolymerisierbare Aufzeichnungsschicht oder von dieser vor der Entwicklung abziehbar ist. Diese Deckschicht bzw. Deckfolie dient vor allem dem Schutz der photopolymerisierbaren Aufzeichnungsschicht bei der Lagerung und Handhabung der lichtempfindlichen Aufzeichnungsmaterialien und auch als Sauerstoffsperre für die photopolymerisierbare Aufzeichnungsschicht. Als besonders geeignet haben sich beispielsweise Deckschichten aus Polyvinylalkoholen oder Polyvinylalkohol-Derivaten bzw., insbesondere für Photoresistfilme, Deckfolien aus Polyolefinen, z.B. Polyethylen oder Polypropylen, erwiesen.

Die Herstellung der erfindungsgemäßen lichtempfindlichen Aufzeichnungselemente kann in an sich bekannter und üblicher Weise durch Herstellung einer homogenen Mischung der die photopolymerisierbare Aufzeichnungsschicht bildenden Komponenten und schichtförmiges Aufbringen dieser Mischung auf den - gegebenenfalls mit einer Zwischenschicht versehenen - dimensionsstabilen Träger erfolgen. Vorteilhafterweise werden die lichtempfindlichen Aufzeichnungselemente hergestellt, indem man die Komponenten der photopolymerisierbaren Aufzeichnungsschicht in einem geeigneten Lösungsmittel bzw. Lösungsmittel-Gemisch löst und diese Lösung durch Gießen, Tauchen, Sprühen oder andere bekannte Auftragstechniken in der gewünschten Schichtstärke auf den Träger aufbringt. Anschließend wird das Lösungsmittel in üblicher Weise entfernt und die photopolymerisierbare Aufzeichnungsschicht getrocknet. Geeignete Lösungsmittel für das Mischen der Komponenten und Aufbringen der photopolymerisierbaren Aufzeichnungsschicht auf den Träger sind u.a. niedere Alkohole, Ketone oder Ester, wie z.B. Methanol, Aceton, Methylethylketon, Ethylcetat und ähnliche, sowie Mischungen hiervon.

Anschließend kann auf die photopolymerisierbare Aufzeichnungsschicht gewünschtenfalls noch die Deckschicht bzw. Deckfolie aufgebracht werden.

Die erfindungsgemäßen lichtempfindlichen Aufzeichnungselemente eignen sich in vorteilhafter Weise für die Herstellung von Druckformen oder Resistmustern nach den hierfür an sich bekannten und üblichen Verfahren. Hierzu wird die photopolymerisierbare Aufzeichnungsschicht - bei Photoresistfilmen und Schichtübertragungsmaterialien nach der Schichtübertragung auf das zu schützende Substrat - bildmäßig mit aktinischem Licht belichtet, wobei sich hierfür die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenon-Impuls-Lampen, aber auch UV-Laser oder Argonlaser eignen. Die von den Lichtquellen emittierte Wellenlänge soll beispielsweise zwischen 230 und 450 nm, bevorzugt zwischen 300 und 420 nm, liegen und insbesondere auf die Eigenabsorption des in der photopolymerisierbaren Aufzeichnungsschicht enthaltenen Photoinitiators abgestimmt sein. Durch die bildmäßige Belichtung mit dem aktinischen Licht wird in den belichteten Bereichen der Aufzeichnungsschicht eine Photopolymerisation ausgelöst, die zu einer Vernetzung und damit Löslichkeitsdifferenzierung zwischen den belichteten und unbelichteten Schichtbereichen führt. Nach der bildmäßigen Belichtung wird die Druckform bzw. das Resistmuster durch Auswaschen der unbelichteten, unvernetzten Bereiche der Aufzeichnungsschicht mit einer wäßrig-alkalischen Entwicklerlösung entwickelt. Das Entwickeln kann durch Waschen, Sprühen, Abreiben oder Ausbürsten etc. erfolgen. Die erfindungsgemäßen Aufzeichnungselemente zeigen dabei einen großen Entwicklungsspielraum und eine sehr geringe Überwaschempfindlichkeit. Als Entwicklerlösungen kommen wäßrig-alkalische Entwicklerlösungen in Betracht, die zur Einstellung des günstigsten pH-Wertes, beispielsweise im Bereich von 8 bis 14, vorzugsweise im Bereich von 9 bis 12, alkalisch reagierende Substanzen, wie z.B. Borax, Dinatriumhydrogenphosphat, Soda, Alkalihydroxide oder organische Basen, wie Di- oder Triethanolamin, in Wasser gelöst enthalten. Die wäßrig-alkalischen Entwicklerlösungen können auch Puffersalze, z.B. wasserlösliche Alkaliphosphate, -silikate, -borate, -acetate oder -benzoate enthalten. Als weitere Bestandteile der Entwicklerlösungen können Netzmittel, vorzugsweise anionische Netzmittel, und gegebenenfalls wasserlösliche Polymere, wie z.B. Natriumcarboxymethylcellulose, Polyvinylalkohol, Polynatriumacrylat und dgl., mitverwendet werden. Obwohl die erfindungsgemäßen Aufzeichnungselemente mit rein wäßrig-alkalischen Entwicklerlösungen ausgewaschen werden können, ist es selbstverständlich grundsätzlich möglich, wenn erforderlich, daß die wäßrig-alkalischen Entwicklerlösungsen auch noch geringe Zusätze von wasserlöslichen, organischen Lösungsmitteln, wie z.B. aliphatischen Alkoholen, enthalten.

Die erfindungsgemäßen lichtempfindlichen Aufzeichnungselemente zeichnen sich durch ihre guten Belichtungseigenschaften und gute Entwickelbarkeit in wäßrig-alkalischen Entwicklerlösungen aus, wodurch es möglich ist, auch sehr feine Bildelemente vorlagengetreu und sicher zu reproduzieren. Auf metallischen oder metalloxidischen Untergründen besitzen die erfindungsgemäßen photopolymerisierbaren Aufzeichnungsschichten eine sehr gute Haftung, ohne daß es bei der Entwicklung der bildmäßig belichteten Aufzeichnungsschicht zur Ausbildung von Restschichtbelägen in den ausgewaschenen Bereichen kommt. Die erfindungsgemäßen lichtempfindlichen Aufzeichnungselemente eignen sich grundsätzlich für alle Anwendungsgebiete der Reprographie und der optischen Informationsfixierung, insbesondere zur Herstellung von Druckformen und Resistmustern.

Die erfindungsgemäßen lichtempfindlichen Aufzeichnungselemente haben wesentlich verbesserte Lichtempfindlichkeit. Vorsensibilisierte Offset-Platten ohne PVAL-Schutzfilm haben dadurch z.T. schnellere Belichtungszeiten als es dem Stand der Technik entspricht.

Aufgrund der intermolekularen Vernetzung des Bindemittels erreicht man extreme Molekulargewichtszunahmen, was in verbesserter Standfestigkeit der Offset-Schicht zum Ausdruck kommt.

PVAL-Schutzfilm tragende fotopolymere Offset-Schichten auf Basis der erfindungsgemäßen lichtempfindlichen Aufzeichnungsträger lassen sich mit Lasern beschreiben und eignen sich für die Computer to plate Herstellung von Druckplatten.

Die Erfindung wird durch die nachfolgenden Beispiele näher erläutert. Die in den Beispielen genannten Teile und Prozente beziehen sich, sofern nicht anders angegeben, auf das Gewicht.

Modifizierung eines carboxylgruppenhaltigen Copolymerisats mit Glycidyl(meth)acrylat:

In einem Reaktionsgefäß wird ein Copolymerisat (K-Wert nach Fikentscher: 22) aus 65 % Methacrylsäuremethylester, 15 % Hydroxypropylacrylat und 20 % Methacrylsäure in Diethylenglykoldimethylether gelöst, so daß eine Lösung von 15 % Feststoffgehalt entsteht. Diese Lösung wird auf 110° C erhitzt und bei dieser Temperatur eine Lösung aus 30 Teilen Glycidylmethacrylat, 2 Teilen eines thermischen Inhibitors (z.B. Xyligen® Al) und 2 Teilen eines Veresterungskatalysators (z.B. Dimethylaminopyridin, N-Methylimidazol oder Tetrabutylammoniumiodid) innerhalb von 2 Stunden gleichmäßig zugetropft. Die Reaktion ist nach etwa 3,5 Stunden beendet. Nach dem Abkühlen wird das resultierende Reaktionsgemisch auf 3 % Feststoffgehalt verdünnt, in Wasser ausgefällt und das gefällte Copolymerisat bei 50° C unter Ölpumpenvakuum getrocknet. Das erhaltene Copolymerisat weist eine Säurezahl von 25 mg KOH/g auf.

Beispiel 1

| | |
|---|---|
| 59 % | des oben beschriebenen mit Glycidylmethacrylat modifizierten carboxylgruppenhaltigen Copolymerisats (SZ: 25) |
| 30 % | Monomer (Diacrylat des 1,4-Butandioldiglycidylethers) |
| 2 % | Michler's Keton |
| 6 % | 2-(4'-Methoxynaphthyl-1')-4,6-bis-(trichlormethyl)-s-triazin |
| 1 % | Bromphenolblau |
| 2 % | Weichmacher (Benzolsulfonsäure-n-butylamid) |

wurden in einem Lösungsmittelgemisch aus 90 Teilen Tetrahydrofuran und 90 Teilen Essigsäureethylester zu einer homogenen 5 %igen Lösung verarbeitet und mittels einer Rakelvorrichtung (Gießspalt 35 $\mu$m, Abzugsgeschwindigkeit 250 mm/Minute) auf elektrolytisch aufgerauhte und anodisch oxidierte Aluminiumträgerbleche, wie sie für Flachdruckplatten typisch sind, aufgetragen.

Nach jeweils 10 minütiger Trocknung bei 80° C resultierte eine photopolymerisierbare Schicht mit einer Trockenschichtdicke von 2,5 $\mu$m (2,7 g/m²). Die so hergestellten Flachdruckplatten (ohne Sauerstoffsperrschicht) verblieben zunächst für 6 Tage in einem verschlossenen Beutel. Danach wurden sie zur Ermittlung der erforderlichen Mindestbelichtungszeit durch einen FOGRA PMS-Teststreifen mit aktinischem Licht belichtet. Nach der Belichtung wurden die Platten mit einer 1 %igen wäßrigen Sodalösung (pH-Wert 11) in 45 Sekunden entwickelt.

Eigenschaften der Aufzeichnungselemente:

    Belichtungszeit:
    30 Sekunden (mit 3 kW Hg-Brenner)
    Auflösung:
    K-Wert (nach FOGRA) 6 bis 8 $\mu$m
    Farbumschlag:
    gut
Stabilität gegen
    Offset-Chemikalien:
    vergleichbar mit dem Stand der Technik
    Druck:
    >160.000 Drucke

Beispiel 2

Beispiel 1 wurde wiederholt; jedoch wurde auf freie Oberfläche der photopolymerisierbaren Schicht der Flachdruckplatten unmittelbar nach der Trocknung eine Sauerstoffsperrschicht aus einem Polyvinylalkohol (Verseifungsgrad 98 %) in einer Schichtdicke von 5 $\mu$m (6 g/m²) aufgebracht. Für diese Flachdruckplatten mit Sauerstoffsperrschicht wurde in gleicher Weise wie für die Platten ohne Sauerstoffsperrschicht die erforderliche Mindestbelichtungszeit und die erzielbare Auflösung durch bildmäßige Belichtung mit aktinischem Licht durch den FOGRA PMS-Teststreifen ermittelt.

Eigenschaften:

    Belichtungszeit:
    1 Sekunde (3 kW Hg-Brenner)
    Auflösung:
    K-Wert (nach FOGRA) 10 bis 12 $\mu$m
    Farbumschlag:
    gut

Beispiel 3

Beispiel 1 wurde wiederholt; jedoch wurde das Copolymer mit Glycidylacrylat statt Glycidylmethacrylat (Herstellung wie beschrieben) umgesetzt und als Bindemittel eingesetzt.

Eigenschaften des daraus hergestellten Aufzeichnungselements:

    Belichtungszeit:
    32 Sekunden (3 kW Hg-Brenner)
    Auflösung:
    K-Wert 10 $\mu$m
    Farbumschlag:
    gut

Beispiel 4

Es wurde entsprechend Beispiel 2 verfahren, an Stelle des Diacrylats des 1,4-Butandioldiglycidylethers wurde jedoch Trimethylolpropantriacrylat eingesetzt und Bromphenolblau wurde durch Victoria Blau ersetzt.

Eigenschaften:

Belichtungszeit:
2 Sekunden
Auflösung:
K-Wert (nach FOGRA) 10 μm

**Ansprüche**

1. Lichtempfindliches, zur Herstellung von Druckformen oder Resistmustern geeignetes Aufzeichnungselement mit einer auf einem dimensionsstabilen Träger aufgebrachten, wäßrig-alkalisch entwickelbaren, ein polymeres Bindemittel, mindestens eine ethylenisch ungesättigte, photopolymerisierbare niedermolekulare Verbindung, mindestens einen Photopolymerisationsinitiator bzw. ein Photopolymerisationsinitiatorsystem sowie gegebenenfalls weitere Zusatz- und/oder Hilfsstoffe enthaltenden, photopolymerisierbaren Aufzeichnungsschicht, die als polymeres Bindemittel mindestens ein in Wasser unlösliches, in wäßrigalkalischen Lösungen jedoch lösliches oder zumindest dispergierbares, filmbildendes Copolymerisat aus Hydroxyalkyl(meth)acrylat, Acrylsäure und/oder Methacrylsäure sowie mindestens einem Monomeren aus der Gruppe Alkylacrylat, Alkylmethacrylat und Vinylaromat enthält, dadurch gekennzeichnet, daß das Copolymerisat aus 10 bis 50 Gew.% mindestens eines Hydroxyalkyl(meth)acrylats, 8 bis 30 Gew.% Acrylsäure und/oder Methacrylsäure und 30 bis 80 Gew.% mindestens eines Monomeren aus der Gruppe Alkylacrylat, Alkylmethacrylat und Vinylaromat, wobei die Carboxylgruppen des Copolymerisats teilweise durch Umsetzung mit Glycidyl(meth)acrylat verestert sind, besteht.

2. Lichtempfindliches Aufzeichnungselement nach Anspruch 1, dadurch gekennzeichnet, daß 10 bis 60 % der Carboxylgruppen des Copolymerisats mit Glycidyl(meth)acrylat verestert sind.

3. Lichtempfindliches Aufzeichnungselement nach Anspruch 1, dadurch gekennzeichnet, daß das Copolymerisat eine Säurezahl von 20 bis 100 mg KOH/g aufweist.

4. Lichtempfindliches Aufzeichnungselement nach einem der Ansprüche 1 bis 3, dadurch kennzeichnet, daß die Copolymerisate als Hydroxyalkyl(meth)acrylate, Monoacrylate und/oder Monomethacrylate von aliphatischen Diolen mit 2 bis 4 C-Atomen einpolymerisiert enthalten.

5. Lichtempfindliches Aufzeichnungselement nach einem der Ansprüche 1 bis 4, dadurch gekennzeichnet, daß die Copolymerisate als Alkyl(meth)acrylat-Comonomere Acrylate und/oder Methacrylate von Monoalkanolen mit 1 bis 4 C-Atomen einpolymerisiert enthalten.

6. Lichtempfindliches Aufzeichnungselement nach einem der Ansprüche 1 bis 5, dadurch gekennzeichnet, daß als polymereres Bindemittel ein Hydroxypropylacrylat/Methacrylsäure/Methylmethacrylat-Copolymerisat enthalten ist.

7. Lichtempfindliches Aufzeichnungselement nach einem der Ansprüche 1 bis 5, dadurch gekennzeichnet, daß in der lichtempfindlichen Aufzeichnungsschicht als polymeres Bindemittel ein Hydroxypropylacrylat/Acrylsäure/Methylmethacrylat-Copolymerisat enthalten ist.

8. Lichtempfindliches Aufzeichnungselement nach einem der Ansprüche 1 bis 5, dadurch kennzeichnet, daß als polymeres Bindemittel ein Hydroxyethylmethacrylat/Methacrylsäure/Methylmethacrylat-Copolymerisat enthalten ist.

9. Lichtempfindliches Aufzeichnungselement nach einem der Ansprüche 1 bis 8, dadurch gekennzeichnet, daß die Copolymerisate 15 bis 45 Gew.% mindestens eines Hydroxyalkyl(meth)acrylats, 10 bis 20 Gew.% Acrylsäure und/oder Methacrylsäure sowie 40 bis 70 Gew.% mindestens eines Alkyl(meth)acrylats einpolymerisiert enthalten, wobei sich die prozentangaben jeweils auf das Copolymerisat beziehen.

10. Lichtempfindliches Aufzeichnungselement gemäß einem der Ansprüche 1 bis 9, dadurch gekennzeichnet, daß die photopolymerisierbare Aufzeichnungsschicht als ethylenisch ungesättigte, photopolymerisierbare niedermolekulare Verbindungen Monomere und/oder Oligomere mit zwei oder mehr Acryloyl-und/oder Methacryloyl-Gruppen enthält.

Patentansprüche für folgende Vertragsstaaten : AT, ES

1. Verfahren zur Herstellung eines lichtempfindlichen, zur Herstellung von Druckformen oder Resistmustern geeigneten Aufzeichnungselements mit einer auf einem dimensionsstabilen Träger aufgebrachten, wäßrig-alkalisch entwikkelbaren, ein polymeres Bindemittel, mindestens eine ethylenisch ungesättigte, photopolymerisierbare niedermolekulare Verbindung, mindestens einen Photopolymerisationsinitiator bzw. ein Photopolymerisationsinitiatorsystem sowie gegebenenfalls weitere Zusatz- und/oder Hilfsstoffe enthaltenden, photopolymerisierbaren Aufzeichnungsschicht, die als polymeres Bindemittel mindestens ein in Wasser unlösliches, in wäßrig-alkalischen Lösungen jedoch lösliches oder zumindest dispergierbares, filmbildendes Copolymerisat aus Hydroxyalkyl-(meth)acrylat, Acrylsäure und/oder Methacrylsäure sowie mindestens einem Monomeren aus der Gruppe Alkylacrylat, Alkylmethacrylat und Vinylaromat enthält, dadurch gekennzeichnet, daß ein Copolymerisat aus 10 bis 50 Gew.% mindestens eines Hydroxyalkyl-(meth)acrylats, 8 bis 30 Gew.% Acrylsäure und/oder Methacrylsäure und 30 bis 80 Gew.% mindestens eines Monomeren aus der Gruppe Alkylacrylat, Alkylmethacrylat und Vinylaromat, wobei die Carboxylgruppen des Copolymerisats teilweise durch Umsetzung mit Glycidyl(meth)acrylat verestert sind, eingesetzt wird.

2. Verfahren nach Anspruch 1, dadurch gekennzeichnet, daß 10 bis 60 % der Carboxylgruppen des Copolymerisats mit Glycidyl(meth)acrylat verestert worden sind.

3. Verfahren nach Anspruch 1, dadurch gekennzeichnet, daß ein Copolymerisat, das eine Säurezahl von 20 bis 100 mg KOH/g aufweist, eingesetzt wird.

4. Verfahren nach einem der Ansprüche 1 bis 3, dadurch gekennzeichnet, daß in das Copolymerisat als Hydroxyalkyl(meth)acrylate Monoacrylate und/oder Monomethacrylate von aliphatischen Diolen mit 2 bis 4 C-Atomen einpolymerisiert worden sind.

5. Verfahren nach einem der Ansprüche 1 bis 4, dadurch gekennzeichnet, daß in das Copolymerisat als Alkyl(meth)acrylat-Comonomere Acrylate und/oder Methacrylate von Monoalkanolen mit 1 bis 4 C-Atomen einpolymerisiert worden sind.

6. Verfahren nach einem der Ansprüche 1 bis 5, dadurch gekennzeichnet, daß als polymeres Bindemittel ein Hydroxypropylacrylat/Methacrylsäure/Methylmethacrylat-Copolymerisat eingesetzt wird.

7. Verfahren nach einem der Ansprüche 1 bis 5, dadurch gekennzeichnet, daß als polymeres Bindemittel ein Hydroxypropylacrylat/Acrylsäure/Methylmethacrylat-Copolymerisat eingesetzt wird.

8. Verfahren nach einem der Ansprüche 1 bis 5, dadurch gekennzeichnet, daß als polymeres Bindemittel ein Hydroxyethylmethacrylat/Methacrylsäure/Methylmethacrylat-Copolymerisat eingesetzt wird.

9. Verfahren nach einem der Ansprüche 1 bis 8, dadurch gekennzeichnet, daß in das copolymerisat 15 bis 45 Gew.% mindestens eines Hydroxyalkyl-(meth)acrylats, 10 bis 20 Gew.% Acrylsäure und/oder Methacrylsäure sowie 40 bis 70 Gew.% mindestens eines Alkyl(meth)acrylats einpolymerisiert werden, wobei sich die Prozentangaben jeweils auf das Copolymerisat beziehen.

10. Verfahren gemäß einem der Ansprüche 1 bis 9, dadurch gekennzeichnet, daß zur Herstellung der photopolymerisierbaren Aufzeichnungsschicht als ethylenisch ungesättigte, photopolymerisierbare niedermolekulare Verbindungen Monomere und/oder Oligomere mit zwei oder mehr Acryloyl-und/oder Methacryloyl-Gruppen eingesetzt werden.

## Claims

1. A photosensitive recording element which is suitable for the production of printing plates or resist images and has a photopolymerizable recording layer which is applied to a dimensionally stable base, can be developed in an aqueous alkaline medium and contains a polymeric binder, one or more ethylenically unsaturated, photopolymerizable, low molecular weight compounds, one or more photopolymerization initiators or a photopolymerization initiator system and with or without further additives and/or assistants, which recording layer contains, as the polymeric binder, one or more filmforming copolymers which are insoluble in water but soluble or dispersible in aqueous alkaline solutions and consist of hydroxyalkyl (meth)acrylate, acrylic acid and/or methacrylic acid and one or more monomers from the group consisting of alkyl acrylates, alkyl methacrylates and vinyl aromatics, wherein the copolymer consists of from 10 to 50% by weight of one or more hydroxyalkyl (meth)acrylates, from 8 to 30% by weight of acrylic acid and/or methacrylic acid and from 30 to 80% by weight of one or more monomers from the group consisting of alkyl acrylates, alkyl methacrylates and vinyl aromatics, some of the carboxyl groups of the copolymer being esterified by reaction with glycidyl (meth)-acrylate.

2. A photosensitive recording element as claimed in claim 1, wherein from 10 to 60% of the carboxyl groups of the copolymer are esterified with glycidyl (meth)acrylate.

3. A photosensitive recording element as claimed in claim 1, wherein the copolymer has an acid number of from 20 to 100 mg of KOH/g.

4. A photosensitive recording element as claimed in any of claims 1 to 3, wherein the copolymers contain, as copolymerized hydroxyalkyl (meth) acrylates, monoacrylates and/or monomethacrylates of aliphatic diols of 2 to 4 carbon atoms.

5. A photosensitive recording element as claimed in any of claims 1 to 4, wherein the copolymers contain, as copolymerized alkyl (meth)acrylate comonomers, acrylates and/or methacrylates of monoalkanols of 1 to 4 carbon atoms.

6. A photosensitive recording element as claimed in any of claims 1 to 5, wherein a hydroxypropyl acrylate/ methacrylic acid/methyl methacrylate copolymer is present as a polymeric binder.

7. A photosensitive recording element as claimed in any of claims 1 to 5, wherein a hydroxypropyl acrylate/ acrylic acid/methyl methacrylate copolymer is present as a polymeric binder in the photosensitive recording layer.

8. A photosensitive recording element as claimed in any of claims 1 to 5, wherein a hydroxyethyl methacrylate/methacrylic acid/methyl methacrylate copolymer is present as a polymeric binder.

9. A photosensitive recording element as claimed in any of claims 1 to 8, wherein the copolymers contain from 15 to 45% by weight of one or more hydroxyalkyl (meth)acrylates, from 10 to 20% by weight of acrylic acid and/or methacrylic acid and from 40 to 70% by weight of one or more alkyl (meth)acrylates as copolymerized units, the percentages in each case being based on the copolymer.

10. A photosensitive recording element as claimed in any of claims 1 to 9, wherein the photopolymerizable recording layer contains, as ethylenically unsaturated, photopolymerizable, low molecular weight compounds, monomers and/or oligomers having two or more acryloyl and/or methacryloyl groups.

Claims for the following Contracting States: AT, ES

1. A process for producing a photosensitive recording element which is suitable for the production of printing plates or resist images and has a photopolymerizable recording layer which is applied to a dimension-ally stable base, can be developed in an aqueous alkaline medium and contains a polymeric binder, one or more ethylenically unsaturated, photopolymerizable, low molecular weight compounds, one or more photopolymerization initiators or a photopolymerization initiator system and with or without further additives and/or assistants, which recording layer contains, as the polymeric binder, one or more film-forming copolymers which are insoluble in water but soluble or dispersible in aqueous alkaline solutions and consist of hydroxyalkyl (meth)-acrylate, acrylic acid and/or methacrylic acid and one or more monomers from the group consisting of alkyl acrylates, alkyl methacrylates and vinyl aromatics, which comprises using a copolymer which consists of from 10 to 50% by weight of one or more hydroxyalkyl (meth)acrylates, from 8 to 30% by weight of acrylic acid and/or methacrylic acid, and from 30 to 80% by weight of one or more monomers from the group consisting of alkyl acrylates, alkyl methacrylates and vinyl aromatics, some of the carboxyl groups of the copolymer being esterified by reaction with glycidyl (meth)acrylate.

2. A process as claimed in claim 1, wherein from 10 to 60% of the carboxyl groups of the copolymer have been esterified with glycidyl (meth)acrylate.

3. A process as claimed in claim 1, wherein the copolymer used has an acid number of from 20 to 100 mg of

4. A process as claimed in any of claims 1 to 3, wherein the hydroxyalkyl (meth)acrylates which have been copolymerized in the copolymer are monoacrylates and/or monomethacrylates of aliphatic diols of 2 to 4 carbon atoms.

5. A process as claimed in any of claims 1 to 4, wherein the alkyl (meth)acrylate comonomers which have been copolymerized in the copolymer are acrylates and/or methacrylates of monoalkanols of 1 to 4 carbon atoms.

6. A process as claimed in any of claims 1 to 5, wherein a hydroxypropylacrylate/methacrylic acid/methyl methacrylate copolymer is used as a polymeric binder.

7. A process as claimed in any of claims 1 to 5, wherein a hydroxypropyl acrylate/acrylic acid/methyl methacrylate copolymer is used as a polymeric binder.

8. A process as claimed in any of claims 1 to 5, wherein a hydroxyethyl methacrylate/methacrylic acid/methyl methacrylate copolymer is used as a polymeric binder.

9. A process as claimed in any of claims 1 to 8, wherein from 15 to 45% by weight of one or more hydroxyalkyl (meth)acrylates, from 10 to 20% by weight of acrylic acid and/or methacrylic acid and from 40 to 70% by weight of one or more alkyl (meth)acrylates are copolymerized in the copolymer, the percentages in each case being based on the copolymer.

10. A process as claimed in any of claims 1 to 9, wherein, as ethylenically unsaturated, photopolymerizable, low molecular weight compounds, monomers and/or oligomers having two or more acryloyl and/or methacryloyl groups are used to produce the photopolymerizable recording layer.

**Revendications**

1. Elément d'enregistrement sensible à la lumière, approprié à la fabrication de formes d'impression ou modèles de réserve ("resist"), ayant une couche d'enregistrement photopolymérisable, développable par voie aqueuse-alcaline, appliquée sur un support stable en dimension, contenant un liant polymère, au moins un composé à bas poids moléculaire, photopolymérisable insaturé éthyléniquement, au moins un initiateur de photopolymérisation ou système initiateur de photopolymérisation ainsi qu'éventuellement d'autres additifs et/ou auxiliaires, couche qui contient, comme liant polymère, au moins un copolymérisat de (méth)acrylate, d'hydroxyalkyle, acide acrylique et/ou acide méthacrylique, filmogène, insoluble dans l'eau cependant soluble ou au moins dispersable dans des solutions aqueuses-alcalines, ainsi qu'au moins un monomère du groupe acrylate d'alkyle, méthacrylate d'alkyle, et aromate vinylique, caractérisé par le fait que le copolymérisat est constitué de 10 à 50 % en poids d'au moins un (méth)acrylate d'hydroxy alkyle, 8 à 30 % en poids d'acide acrylique et/ou acide méthacrylique et 30 à 80 % en poids d'au moins un monomère du groupe acrylate d'alkyle, méthacrylate d'alkyle, et aromate vinylique, les groupes carboxyle du copolymérisat étant partiellement estérifiés par réaction avec du (méth)acrylate de glycidyle.

2. Elément d'enregistrement sensible à la lumière, selon la revendication 1, caractérisé par le fait que 10 à 60 % des groupes carboxyle de copolymérisat sont estérifiés par réaction avec du (méth)acrylate de glycidyle.

3. Elément d'enregistrement sensible à la lumière, selon la revendication 1, caractérisé par le fait que le copolymérisat présente un indice d'acide de 20 à 100 mg KOH/g.

4. Elément d'enregistrement sensible à la lumière selon l'une des revendications 1 à 3, caractérisé par les copolymérisats contiennent, mis en polylérisation, comme (méth)acrylates d'hydroxyalkyle, des monoacrylates et/ou monométhacrylates de diolène aliphatique ayant 2 à 4 atomes C.

5. Elément d'enregistrement sensible à la lumière, sleon l'une des revendications 1 à 4, caractérisé par le fait que les copolymérisats contiennent, mis en polymérisation, comme comonomères (méth)acrylate d'alkyle, des acrylates et/ou méthacrylates de monoalcanolène ayant 1 à 4 atomes C.

6. Elément d'enregistrement sensible à la lumière, selon l'une des revendications 1 à 5, caractérisé par le fait qu'est contenu, comme liant polymère, un copolymérisat d'acrylate d'hydroxypropyle/acide méthacrylique/méthacrylate de méthyle.

7. Elément d'enregistrement sensible à la lumière, selon l'une des revendications 1 à 5, caractérisé par le fait que, dans la couche d'enregistrement sensible à la lumière, est contenu, comme liant polymère, un copolymérisat d'acrylate d'hydroxypropyle/acide méthacrylique/méthacrylate de méthyle.

8. Elément d'enregistrement sensible à la lumière, selon l'une des revendications 1 à 5 qu'est contenu, comme liant polymère, un copolymérisat de méthacrylate d'hydroxyéthyle/acide méthacrylique/méthacrylate de méthyle.

9. Elément d'enregistrement sensible à la lumière selon l'une des revendications 1 à 8, caractérisé par le fait que les copolymérisats contiennent, en polymérisation 15 à 45 % en poids d'au moins un (méth)acrylate d'hydroxyalkyle, 10 à 20 % en poids d'acide acrylique et/ou acide méthacrylique, ainsi que 40 à 70 % en poids d'au moins un (méth)acrylate d'alkyle, les pourcentages étant rapportés chacun au copolymérisat.

10. Elément d'enregistrement sensible à la lumière selon l'une des revendications 1 à 9 caractérisé par le fait que la couche d'enregistrement photopolymérisable contient, comme composés à bas poids moléculaire, photopolymérisable, insaturé éthyléniquement, des monomères et/ou oligomères ayant deux ou plus de deux groupes acryloyle et/ou méthacryloyle.

Revendications pour les Etats contractant suivants :
AT, ES

1. Procédé de préparation d'un élément d'enregistrement sensible à la lumière, approprié à la fabrication de formes d'impression ou modèles de réserve ("resist"), ayant une couche d'enregistrement photopolymérisable, développable par voie aqueuse-alcaline, appliquée sur un support stable en dimension, contenant un liant polymère, au moins un composé à bas poids moléculaire, photopolymérisable, insaturé éthyléniquement, au moins un initiateur de photopolymérisation ou système initiateur de photopolymérisation ainsi qu'éventuellement d'autres additifs et/ou auxiliaires, couche qui contient, comme liant polymère, au moins un copolymérisat de (méth)acrylate, d'hydroxyalkyle, acide acrylique et/ou acide méthacrylique, filmogène, insoluble dans l'eau cependant soluble ou au moins dispersable dans des solutions aqueuses-alcalines, ainsi qu'au moins un monomère du groupe acrylate d'alkyle, méthacrylate d'alkyle, et aromate vinylique, caractérisé par le fait que l'on met en réaction un copolymérisat constitué de 10 à 50 % en poids d'au moins un (méth)acrylate d'hydroxyalkyle, 8 à 30 % en poids d'acide acrylique et/ou acide méthacrylique et 30 à 80 % en poids d'au moins un monomère du groupe acrylate d'alkyle, méthacrylate d'alkyle, et aromate vinylique, les groupes carboxyle du copolymérisat étant partiellement estérifiés par réaction avec du (méth)acrylate de glycidyle.

2. Procédé selon la revendication 1, caractérisé par le fait que 10 à 60 % des groupes carboxyle de copolymérisat sont estérifiés par réaction avec du (méth)acrylate de glycidyle.

3. Procédé selon la revendication 1, caractérisé par le fait qu'on met a réagir un copolymérisat qui présente un indice d'acide de 20 à 100 mg KOH/g.

4. Procédé selon l'une des revendications 1 à 3, caractérisé par le fait que, dans le copolymérisat on a mis en polymérisation, comme (méth)acrylates d'hydroxyalkyle, des monoacrylates et/ou monométhacrylates de diolène aliphatique ayant 2 à 4 atomes C.

5. Procédé selon l'une des revendications 1 à 4, caractérisé par le fait que dans le copolymérisat on a mis en polymérisation, comme comonomères (méth) acrylate d'alkyle, des acrylates et/ou méthacrylates de monoalcanolène ayant 1 à 4 atomes C.

6. Procédé selon l'une des revendications 1 à 5, caractérisé par le fait qu'on a mis en réaction, comme liant polymère, un copolymérisat d'acrylate d'hydroxypropyle/acide méthacrylique/méthacrylate de méthyle.

7. Procédé selon l'une des revendications 1 à 5, caractérisé par le fait qu'on a mis en réaction, comme liant polymère, un copolymérisat d'acrylate d'hydroxypropyle/acide méthacrylique/méthacrylate de méthyle.

8. Procédé selon l'une des revendications 1 à 5, caractérisé par le fait qu'on a mis en réaction, comme liant polymère, un copolymérisat de méthacrylate d'hydroxyéthyle/acide méthacrylique/méthacrylate de méthyle.

9. Procédé selon l'une des revendications 1 à 8, caractérisé par le fait que dans le copolymérisat, on a mis en polymérisation 15 à 45 % en poids d'au moins un (méth)acrylate d'hydroxyalkyle, 10 à 20 % en poids d'acide acrylique et/ou acide méthacrylique, ainsi que 40 à 70 % en poids d'au moins (méth)acrylate d'alkyle, les pourcentages sont rapportés chacun au copolymérisat.

10. Porcédé selon l'une des revendications 1 à 9, caractérisé par le fait que pour préparer la couche d'enregistrement photopolymérisable, on a mis en réaction, comme composé à bas poids moléculaire, photopolymérisable, insaturé éthyléniquement, des monomères et/ou oligomères ayant deux ou plus de deux groupes acryloyle et/ou méthacryloyle.